(19) Europäisches Patentamt
European Patent Office
Office européen des brevets

(11) Numéro de publication: **0 099 810**
**B1**

(12) **FASCICULE DE BREVET EUROPEEN**

(45) Date de publication du fascicule du brevet: **18.05.88**

(21) Numéro de dépôt: **83401414.4**

(22) Date de dépôt: **08.07.83**

(51) Int. Cl.$^4$: **G 01 N 24/08,** G 01 N 24/02, G 01 N 33/00

# (54) Procédé pour déterminer les origines bio- et/ou techno-synthétiques de substances organiques et moyens pour sa mise en oeuvre.

(30) Priorité: **09.07.82 FR 8212148**

(43) Date de publication de la demande:
**01.02.84 Bulletin 84/05**

(45) Mention de la délivrance du brevet:
**18.05.88 Bulletin 88/20**

(84) Etats contractants désignés:
**DE FR GB**

(56) Documents cités:
**US-A-3 925 721**
**ANALYTICAL CHEMISTRY, vol. 42, no. 4, avril 1970, pages 109A-112A, New York, USA. T. C. FARRAR: "Pulsed and fourier transform NMR spectroscopy"**
**ANALYTICAL CHEMISTRY, vol. 51, no. 2, février 1979, pages 224A-232A, American Chemical Society, USA. C. A. LUCCHESI: "The analytical approach"**

(73) Titulaire: **CENTRE NATIONAL DE LA RECHERCHE SCIENTIFIQUE (CNRS)**
**15, Quai Anatole France**
**F-75007 Paris (FR)**

(72) Inventeur: **Bengsch, Eberhard Richard**
**81 rue de la Somme**
**F-45160 Olivet (FR)**
Inventeur: **Grivet, Jean-Philippe**
**321 rue de la Vallée**
**F-45160 Olivet (FR)**
Inventeur: **Schulten, Hans-Rolf**
**Flotostrasse 12**
**D-5090 Leverkusen (DE)**

(56) References cited:
**JOURNAL OF APPLIED SPECTROSCOPY, vol. 27, no. 5, novembre 1977, pages 1440-1443, Plenum Publishing Corporation, New York, USA. A. G. ZHURAVLEV et al.: "Paramagnetic shifts in the PMR spectra of electron-donor organic compounds, induced by nitrogen tetroxide"**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

**EP 0 099 810 B1**

(56) References cited:

**PATENTS ABSTRACTS OF JAPAN, vol. 6, no. 237 (P-157)1115r, 25 novembre 1982**

**TETRAHEDRON LETTERS, vol. 22, no. 36, 1981, pages 3525-3528, Pergamon Press Ltd., Oxford, GB. G. J. MARTIN et al.: "Deuterium labelling at the natural abundance level as studied by high field quantitative 2H NMR"**

**Description**

La présente invention concerne un procédé pour déterminer, qualitativement, le cas échéant quantitativement, les origines bio- et/ou techno-synthétiques de substances organiques. En effet, pour des substances organiques de toutes sortes, l'indication de leur origine peut être d'une grande importance, notamment dans les domaines de la chimie, de la biologie, de la chimie alimentaire, de la médecine, de la pharmacologie et dans tous les autres domaines où il importe d'élucider l'origine de ladite substance.

Les quelques procédés connus pour la détermination de l'origine de substances organiques sont généralement baés sur la mise en évidence d'un ou de plusieurs produits secondaires ou d'impuretés qui accompagnent de manière caractéristique la substance organique considérée en fonction de son'mode de synthèse. La possibilité d'eliminer ou d'ajouter un tel produit indicateur/marqueur, chimiquement différent de la substance à examiner, entraîne l'inconvénient de pouvoir fausser le résultat d'une éventuelle analyse dans le sens souhaité.

En conséquence, une analyse à l'abri de toute falsification ne peut être effectuée que directement sur la substance elle-même, à l'état chimiquement pur. Une substance pure est représentée par sa formule chimique structurale qui est identique pour un composé donné, quelle que soit son origine: biologique, technique ou mixte.

Il convient donc de rechercher des différences caractéristiques et reproductibles à l'intérieure de l'identité chimique, c'est-à-dire d'utiliser le fait que la formule chimique structurale n'est qu'une approximation de la réalité moléculaire qui couvre en effet des structures isotopiques différentes.

On sait en effet que, pour une substance donnée, il existe dans le cadre de sa forme structurale plusieurs espèces isotopiques dénommées couramment "isotopomères". Leur nombre croît rapidement avec la complexité de la molécule. A titre d'exemple, on indique ci-après l'isotopie carbone-13/carbone-12 pour l'acide acétique:

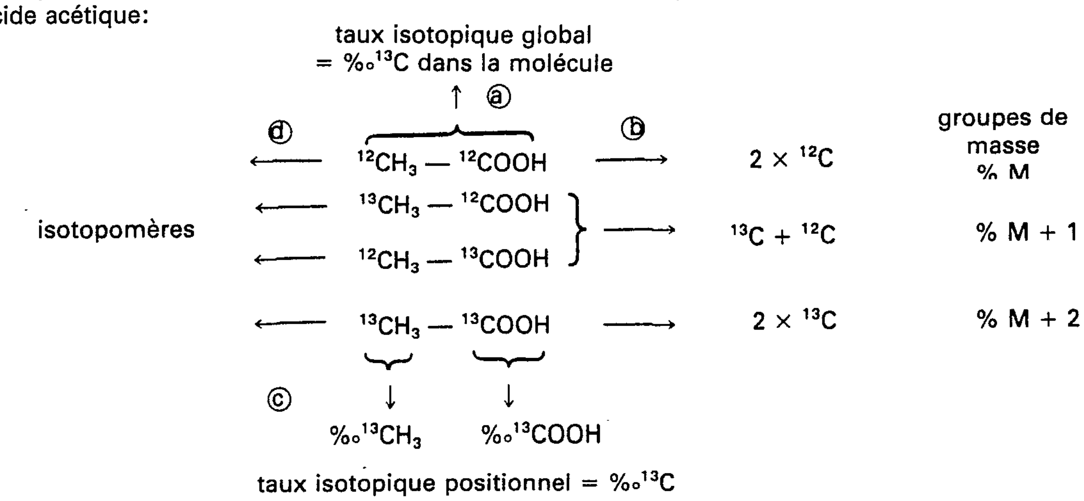


On définit ainsi, aussi bien pour ce cas particulier que de manière générale, 4 paramètres d'identification isotopique:

a. Le taux isotopique global (a) qui correspond ici à l'abondance moyenne du carbone-13 dans les 2 positions possibles.

b. Les groupes de masse dans lesquels on trouve la somme des concentrations des isotopomères présentant une masse identique, mais une répartition isotopique différente.

c. Le taux isotopique position par position. Il existe autant de taux isotopiques positionnels (c) que de nombre de positions non équivalentes N susceptibles d'une substitution isotopique. Dans le cas de l'acide acétique $^{12}C \rightarrow {}^{13}C$ est égale à 2.

d. Les espèces à identité isotopique également dénommées isotopomères. L'isotopomère constitue le véritable corps chimique élémentaire. Il y a $2^N$ isotopomères lorsqu'il y a N positions non équivalentes, et $2^N(N'+1)$ ... lorsqu'il y a en plus N' positions équivalentes, et ainsi de suite. Ainsi, le nombre des isotopomères pour l'acétate de sodium est $2^2=4$ par rapport à l'isotopie carbone-13/carbone-12, 3+1=4 par rapport au deutérium/protium. Leur nombre total par rapport aux atomes de carbone et d'hydrogène est donc de 16.

L'étude des isotopomères a déjà fait l'objet de nombreux travaux qui ont été effectués en milieu hautement enrichi.

A cet effet, on peut les références ci-après concernant, d'lune part, les travaux en milieu hautement enrichi relatifs au deutérium: (E. BENGSCH, M. CORVAL, Préparation de l'éthanol deutérié $CH_2DCH_2OH$. Bull. Soc. Chim. France 1963, 1867—68 — E. BENGSCH. Préparation de quelques homologues isotopiques de l'éthanol. Etude physico-chimique des conditions de leur synthèse et de leur purification. Diplôme d'Etudes Supérieures. Faculté des Sciences de Paris, mai 1966 — E. BENGSCH. Préparation et analyse spectroscopique des espèces isotopiques deutériées de l'éthanol $C_2H_{5-n}D_nOH$. Bull Soc. Chim. France *4B,* 1971, 15 — E. BENGSCH. Isotopieeffekte in der Protonen- und Deuteronenresonanz der deuterierten

Homologen des Äthanols. Comptes-Rendus de l'Assemblée de la Société Chimique de la R.F.A., septembre 1971, p. 171—2 — E. BENGSCH. Contribution à l'étude de la molécule d'éthanol par résonance magnétique nucléaire. Deutériation et analyse positionnelle. Résonance du proton et du deuton. Effets d'isotopie. Doctorat d'Etat, Université de Paris VI, juin 1972 — E. BENGSCH, M. CORVAL, M. DELEAUMONY. Préparation des éthanols deutériés $C_2H_{5-n}D_nOH$. Bull. Soc. Chim. France, 1973, 1788—93 — E. BENGSCH. Résonance magnétique Nucléaire du proton et du carbone-13: effets d'isotopie observés avec les méthanols deutéries. Actualité chimique, 1973, n° 4, 100 — E. BENGSCH, M. CORVAL, G. L. MARTIN. Analyse isotopique de mélanges d'éthanols deutériés $C_2H_{5-n}H_nOH$. Organic Magnetic Resonance *6*, 1974, 195—9); d'autre part, les travaux en milieu hautement enrichi relatifs au carbone-13 sont: (E. BENGSCH, M. PTAK). Analyse des spectres RMN du carbone-13 pour quelques acides aminés enrichis et les peptides correspondants. Dans "Stable Isotopes in the Life Sciences". Agence Internationale à l'Energie Atomique I.A.E.A., Vienne, Autriche, 1977, p. 197—206 — E. BENGSCH, J.-Ph. GRIVET, H. R. SCHULTEN. Non-statistical label distribution in biosynthesis $^{13}C$ enriched amino acids. 9e Conférence Internationale de RMN dans les Systèmes Biologiques, 1—6 septembre 1980, Bendor/Marseille — E. BENGSCH, J.-Ph. GRIVET, H. R. SCHULTEN. Non-statistical label distribution in bio-synthetic enriched amino acids. Z. Naturf. *36b*, 1981, 1989—1996 — E. BENGSCH, J.-Ph. GRIVET, H. R. SCHULTEN Inter- and Intramolecular isotopic heterogeneity in biosynthetic $^{13}C$ — enriched amino acids dans Analytical Chemistry Symposium Series "Stable Isotopes" vol. 11, p. 587—92 édité par H. L. Schmidt, H. Förstel, K. Heinzinger Elsevier Amsterdam, Oxford, New York 1982.

En ce qui concerne les molécules biologiques, il est connu que la répartition globale et positionnelle des isotopes n'est ni statistique ni uniforme (H. L. SCHMIDT et F. J. WINKLER dans Ber. Deutsch Bot. Ges. *92,* 1979, p. 185—191 et H. ZIEGLER dans Ber. Deutsch Bot. Ges. *92,* 1979, p., 169—184). Elle varie au contraire en fonction des perturbations des conditions intracellulaires du fait que les systèmes enzymatiques de la matière vivante préfèrent plus ou moins l'isotope naturel majoritaire, c'est-à-dire le carbone-12 au carbone-13, le protium au deutérium, etc. Il en résulte pour les substances biologiques une discrimination en isotope lourd, créée avant tout par quelques réactions clefs de la photosynthèse. Cette discrimination se maintient essentiellement à travers le métabolisme secondaire, le cas échéant également à travers la chaîne alimentaire plante-herbivore-carnivore, de telle sorte que l'on peut espérer remonter à l'origine végétale, c'est-à-dire photosynthétique d'une substance donnée, lorsqu'on réussit à:

1. déterminer un nombre suffisant de paramères isotopiques, a, b, c, d;

2. systématiser, malgré la complexité des flux métaboliques, le phénomène de la réparatition isotopique, c'est-à-dire se baser sur des standards reproductibles et prévisibles.

On a constaté notamment que, dans une molécule donnée, les groupes à caractère hydrophile, tels que par exemple —COOC,—$CH_nOH$ avec n = 0, 1 ou 2, et/ou les groupes facilement recyclables pendant le métabolisme, tels que par exemple le groupe —COOH, sont enrichis en isotope lourd par rapport à la teneur isotopique moyenne de la molécule, alors que les groupes hydrophobes, tels que par exemple —$CH_3$ ou —$CH_2$—, sont appauvris en isotope lourd.

Au contraire, pour une substance organique obtenue par synthèse technique, la répartition en isotopes est différente et tend à être homogène, car les procédés de synthèse fonctionnent avec des rendements proches de 100%. Ils évitent la ramification du flux de la matière; la totalité de celle-ci ou presque est convertie, les compositions isotopiques initiales et finales des fractions moléculaires impliquées dans la réaction sont très proches. Les cas de disproportions isotopiques rencontrés dans les procédés de synthèse sont limités à quelques positions et prévisibles en fonction du procédé de synthèse utilisé.

Il en résulte que les caractéristiques isotopiques d'une substance donnée devraient permettre d'identifier l'origine de celle-ci.

On a déjà proposé de déterminer l'origine d'une substance organique par mesure, en abondance naturelle, du taux isotopique positionnel du deutérium par résonance magnétique nucléaire. A cet effet, on peut citer l'article de G. J. MARTIN et M. L. MARTIN paru dans Tetrahedron Letters vol. 22, n° 36, p. 3525—3528, 1981. Cependant, étant donné que l'eau lourde est un produit industriel bon marché, on peut par son adjonction fausser le cas échéant le résultat d'une telle détermination dans un sens souhaité. De plus, une telle détermination peut parfois n'être significative que de l'environnement de la substance à examiner, ce qui permet alors de définir plutôt les conditions climatiques de sa biosynthèse, sa provenance géographique et d'autres facteurs liés au milieu aqueux des biosynthèses. En effet, on a constaté que, par exemple, l'alcool éthylique présente, en fonction de son origine, des modifications assez spectaculaires de son taux de deutérium. Cependant, il s'est avéré que ces modifications sont extrêment sensibles aux facteurs d'environnement définis ci-dessus et à la morphologie de la plante, de telle sorte qu'elles ne peuvent pas dans tous les cas servir d'unique critère pour déterminer l'origine biologique et/ou synthétique d'un alcool.

Il est donc nécessaire de déterminer d'autres caractéristiques isotopiques significatives de l'origine bio- et/ou technosynthétique d'une substance, par exemple d'un alcool.

Jusqu'à présent, il n'a été possible de déterminer, en abondance naturelle pour le carbone-13, que le taux isotopique global (a) (par combustion totale de la molécule) et, de manière précaire et incertaine, les groupes de masse (b). Par ailleurs, on a tenté de déterminer les facteurs (c) et (d) selon la technique, comprenant des dégradations chimiques quantitatives, la combustion des fragments recueillis à l'état pur et sand perte et la spectrométrie de masse des produits de combustion ($CO_2$, $H_2O$). Cette technique est très

longue à réaliser, limité à quelques composés particuliers très simples et elle est peu faible car elle exige des réactions chimiques susceptibles d'entraîner elles-mêmes un fractionnement isotopique.

On a maintenant trouvé un nouveau procédé pour déterminer qualitativement et/ou quantitativement l'origine d'une substance organique donnée, qui consiste à déterminer la répartition isotopique positionnelle d'au moins un isotope léger, stable et magnétiquement actif autre que le deutérium par résonance magnétique nucléaire quantitative. Sous son aspect général, le procédé de l'invention consiste à enregistrer par résonance magnétique nucléaire quantitative par transformée de Fourier, dans des conditions assurant une sensibilité suffisante et une parfaire proportionnalité entre le nombre de noyaux résonnants et l'amplitude du signal, les spectres des noyaux concernés, en particulier ceux du carbone-13, à calculer la surface des différentes raies et à comparer ces surfaces par rapport à la moyenne desdites surfaces.

Le procédé de l'invention rend accessibles de façon inattendue les paramètres (c) et (d) définis ci-dessus, en abondance naturelle, malgré les préjugés techniques existants notamment pour le carbone-13 selon lesquels:

1. on ne pouvait pas réaliser par RMN, en particulier du carbone-13, une analyse quantitative assez précise pour déceler les différences des abondances isotopiques naturelles, telles qu'elles résultent de la faible sélectivité d'une séquence de réaction chimiques et biologiques;

2. si cela s'était avéré possible pour quelques cas exceptionnels et en milieu enrichi, il était impensable jusqu'à présent d'effectuer la même détermination sur des composés présentant seulement une abondance naturelle, par exemple en carbone-13;

3. les éventuelles règles trouvées pour la répartition intramoléculaire (c) systématique des isotopes dans les biomolécules, règles établies pour les milieux enrichis, ne sont pas transposables aux composés formés sous conditions d'abondance isotopique naturelle.

L'exploitation quantitative du spectre R.M.N. de la substance à examiner peut être effectuée par planimétrie, par intégration automatique et/ou par simulation spectrale itérative, c'est-à-dire en modifiant pour chaque isotopomère contribuant au spectre global et dont on connaît les parémètres spectroscopiques, son poids jusqu'à ce que les spectres calculés deviennent identiques aux spectres enregistrés.

Selon un autre mode de réalisation, on peut avantageusement procéder à une mesure différentielle par rapport à une position donnée dans la molécule prise comme référence isotopique interne.

Un autre mode de réalisation consiste dans l'enregistrement, dans des conditions identiques, des spectres en module. Ce mode de réalisation accentue la faible différence qui existe entre les différents signaux, c'est-à-dire que les pics les plus faibles sont dimimués et les pics les plus grands sont relativement augmentés, de telle sorte qu'on peut qualitativement reconnaître plus facilement les positions enrichies ou appauvries en carbone-13 sand intégration.

L'exploitation quantitative de l'isotopie intramoléculaire réalisée selon l'invention peut être avantageusement complétée par la détermination des groupes à masse égale (b) par spectrométrie de masse, de préférence à désorption par champ, méthode sans fragmentation des molécules et de ce fait particulièrement apte à des déterminations isotopiques quantitatives. Cette méthode qui utilise de préférence la cationisation à l'aide d'un mêtal mono-isotopique comme le sodium convient particulièrement aux molécules biologiques qui sont dans la plupart des cas des molécules polaires peu volatiles et sujettes à fragmentation et le cas échéant relativement compliquées; les méthodes classiques de la spectrométrie de masse ne laissent espérer aucun résultat pour ce type de molécules. L'obtention simple, rapide et précise des valeurs pour les groupes de masse (paramètres a et b définis précédemment) est assurée par l'utilisation d'un enregistreur permettant l'accumulation de spectres (W. D. LEHMANN, H. R. SCHULTEN. Quantitative Feld désorption — Massenspektroskopie VI, Z. Anal. Chem. *289,* 1978, 11—16 — H. M. SCHIEBEL, H. R. SCHULTEN. Depletion of $^{13}$Carbon in the Biosynthesis of Vitamin $B_{12}$. Naturwissenschaften *67,* 1980, 256—257). En outre, cette méthode a l'avantage de n'exiger que quelques microgrammes de substances.

Ainsi, selon un mode de réalisation préféré de l'invention, on combine, pour déterminer l'origine bio- et/ou techno-synthétique d'une substance organique, la résonance magnétique nucléaire quantitative et la spectrométrie de masse, de préférence à désorption par champ. Dans ce cas, les intensités positionnelles déterminées selon l'invention peuvent être exprimées en taux absolus de carbone.

Pour la mise en oeuvre du procédé de l'invention, la substance à examiner doit être en solution relativement concentrée. L'asservissement champ-fréquence est réalisé soit sur la résponance deutonique du solvant, si celui-ci est disponible sous forme deutériée ($D_2O$, $CDCl_3$ ou similaires), sont sur une substance deutériée miscible au mélange solvant/substance à examiner, soit sur un corps de référence placé dans un tube coaxial.

On indiquera ci-après les conditions particulièrement préférées pour l'enregistrement par R.M.N. des spectres des substances à examiner, que assurent une sensibilité suffisante et une parfaite proportionnalité entre le nombre de noyaux résonnants et l'amplitude du signal:

— l'angle de nutation est de 90°,

— le nombre de passages accumulés doit être compris entre 100 et 50 000, de préférence entre 5 000 et 20 000, avantageusement de 5 000,

— la résolution numérique doit être comprise entre 0,8 et 0,05 Hz/point, de préférence 0,1 à 0,2.

La digitalisation du signal doit être réalisée avec soin. Si le nombre de points par hertz est trop faible, les aires mesurées pour les raies fines sont sous-évaluées, ce qui fausse ainsi l'analyse isotopique.

Pour éviter cet inconvénient, on doit soit:

a) comparer préférentiellement des largeurs semblables,

b) choisir une résolution numérique telle que la raie la plus fine soit représentée par au moins 10 points,

c) choisir un algorithme d'intégration tel que l'erreur de troncation soit inférieure à 0,5%,

d) rendre toutes les largeurs pratiquement semblables soit par une multiplication exponentielle du signal avant la transformée de Fourier, soit par addition à l'échantillon d'un agent relaxant.

On réalise un découplage total des protons. Pour éviter toute altération du résultat par des effets d'isotopie sur l'effet nucléaire OVERHAUSER, on supprime ce dernier par la méthode de l'irradiation alternée décrite par R. FREEDMAN, H. D. HILL et R. KAPTEIN (Proton-Decoupled NMR Spectra of Carbon-13 with the Nuclear OVERHAUSER Effect Suppressed. J. Magn. Res. *7*, 1972, 327—329).

Pour assurer le rétablissement quasi parfait de l'équilibre de BOLTZMANN après chaque irradiation, on observe après chaque passage un temps d'attente $T_3$ qui correspond à 10 fois les temps de relaxation $T_2$ peu différent de $T_1$ du noyau le plus lent.

Afin de réduire les temps de relaxation du carbone-13 à des valeurs de l'ordre d'une seconde, on ajoute des agents relaxants connus tels que, par example, le trichlorure de gadolinium. Quand l'échantillon ne doit pas être contaminé par des ions paramagnétiques, il faut accepter une durée d'enregistrement plus longue pouvant atteindre plusieurs jours lorsqu'on veut tenir compte des carbones quaternaires.

En cas de superposition des signaux à analyser ou lorsqu'on veut déterminer des isotopomères (paramètres d), on procède à des simulations spectrales (programmes BRUKER IIR CAL et LAOCOON 4 B) en modifiant itérativement la contribution qu'apporte chaque espèce isotopique au spectre global, le cas échéant à l'aide d'une planimétrie différentielle entre les spectres expérimentaux et simulés jusqu'à ce qu'il y ait identité. Pour ce faire, il faut tenir compte des paramètres R.M.N.: positions de signaux, les largeurs des raies, le cas échéant des couplages et des effets d'isotopie sur ces paramètres.

En général, les signaux du carbone-13 sont relativement espacés et certains spectromètres de R.M.N. ne possèdent par une caractéristique d'intensité (courbe de réponse) rigoureusement identique sur toute la largeur du spectre dans le domaine de fréquences utilisées. En général, cette courbe de réponse est principalement déterminée par les caractéristiques du filtre passe-bas utilisé avant le convertisseur analogue numérique. On peut s'affranchir en partie de cet effet en choisissant une bande passante bien supérieure, par exemple trois fois supérieure à la largeur spectrale intéressante. Cependant, ceci entraîne un diminution importante du rapport signal/bruit, donc de la sensibilité.

On peut partiellement parvenir à éliminer cette source d'erreur en enrigstrant les spectres des composés biologiques et techniques à comparer dans des conditions rigoureusement identiques.

Cependant, le moyen idéal pour palier cet inconvénient consiste à calibrer le spectromètre avec un tube de calibrage contenant un mélange défini de composés qui ne produisent chacun qu'une seule raie en R.M.N. pour un isotope donné et dont on connaît pour chacun la teneur isotopique globale. Ce tube de calibrage consitue en autre objet de l'invention. Les composés constituant le mélange de calibrage sont pour la R.M.N. du carbone-13 des composés à carbones équivalents, tous miscibles entre eux dans des proportions données, stables, inertes les uns par rapport aux autres et décoposables par combustion.

Le mélange de calibrge préféré est un mélange de composés en quantités sensiblement égales en carbone-13, dont les raies sont espacées sur toute la largeur du spectre de façon relativement régulière.

A titre d'exemples de mélanges de calibrages appropriés aux fins de l'invention, on citera le mélange dans l'eau lourde des composés suivants pour lesquels on a indiqué parenthèses la position relative de leur signal par rapport au dométhylsulfoxyde, exprimée en ppm et comptée positivement vers les champs faibles.

— thiocyanate de sodium NaSCN (+ 100 ppm)

— urée $NH_2$ CO $NH_2$ (+ 70 ppm)

— diméthylsulfoxyde $(CH_3)_2$ SO

— glycol $(CH_2OH)_2$ (−13,6 ppm)

— alcool méthylique $CH_3OH$ (−23,7 ppm)

en des quantités telles que chaque composé apporte la même quantité molaire de carbone.

L'invention a également pour objet le tube de calibrage contenant un mélange du type défini précédemment, le tube étant de préférence un tube scellé.

Le calibrage interne du spectre peut être automatisé à l'aide d'une fonction polynomiale de compensation. On introduit alors dans l'ordinateur les caractéristiques du mélange de calibrage, on enregistre le spectre du mélange de calibrage et l'ordinateur établit une fonction polynomiale de compensation qui neutralise les fluctuations dans la courbe de réponse du spectromètre, de telle sorte que pour chaque signal, indépendamment de sa position, la surface devienne strictement proportionnelle au nombre réel de noyaux $^{13}C$.

La mise en oeuvre du procédé de l'invention ne nécessite pas l'utilisation d'un étalon de référence.

Le procédé de l'invention permet de déterminer l'origine bio et/ou techno-synthétique d'une substance donnée en confrontant les caractéristiques isotopiques obtenus par le procédé de l'invention avec celles de substances témoins ou substances de référence.

En l'absence de telles substances témoins, le procédé de l'invention permet également de donner des indications sur l'origine de la substance en utilisant comme moyen standard d'analyse une matrice de répartition isotopique prédéterminée par la formule chimique structurale, schéma isotopique interne selon lequel, en particulier pour l'élément carbone, les groupes à caractère hydrophile et/ou facilement recyclables pendant le métabolisme sont enrichis en isotope lourd par rapport à la teneur isotopique moyenne de la molécule, les groupes à caractère hydrophobe par contre sont appauvris en isotope lourd.

Dans le cas de molécules complexes, il est suffisant de déterminer quelques-uns des $2^N(N'+1)\ (N''+2)$ ... isotopomères possibles, respectivement en prenant en considération seulement certaines, de préférence deux positions particulièrement révélatrices, quant à leur taux en isotope lourd, l'un par rapport à l'autre.

Le spectromètre R.M.N. utilisé pour la mise en oeuvre de l'invention peut avantageusement être couplé avec un microprocesseur, dans lequel on mémorise d'abord des compositions isotopiques standards, par exemple pour les substances en provenance de plantes $C_3$, $C_4$, CAM (mécanisme mixte entre $C_3$ et $C_4$) ou de cultures sousmarines et pour les substances techniques. On peut également introduire certains facteurs correctifs empiriques qui tiennent compte de facteurs climatiques, géographiques de l'environnement et de la morphologie de la plante d'origine, factuers qui provoquent des fluctuations isotopiques. On introduit ensuite dans ce microprocesseur les caractéristiques spectrales de l'échantillon, en particulier celles concernant l'isotope carbone-13.

On notera que le procédé de l'invention est avantageusement réalisé avec l'isotope carbone-13, mais peut également être effectué pour l'azote-15, l'oxygène-17 et le soufre-33.

De plus, on peut combiner la détermination de l'isotopie du carbone-13 avec celle du deutérium ou des autres isotopes cités ci-dessus.

L'invention va être maintenant illustrée par les exemples non limitatifs ci-après, dans lesquels on utilise le symbole

$$\underset{\downarrow}{CH_3}—\overset{\uparrow}{C}OOH$$

pour caractériser semi-quantitativement und hétérogénéité intromoléculaire typique d'un acide acétique plus pauvre en carbone-13 méthylique et plus riche en carbone-13 carboxylique.

Les spectres enregistrés selon les exemples ci-après l'ont été sur des spectromètres BRUKER WH 90, WP 200 SY et WM 400.

Exemple 1

*Détermination de l'origine de l'acide acétique.*

La méthode est basée ici sur l'unique détermination par R.M.N. quantitative du rapport intramoléculaire $^{13}CH_3/^{13}COOH$.

L'acide acétique est un composé-clef dans la biosynthèse. Cette molécule ultra-simple est pratiquement la seule pour laquelle on a réussi à déterminer les distributions internes du carbone-13 par la technique antérieure (voir E. R. SCHMIDT, H. GRUNDMANN, I. FOGY. Intramolecular $^{13}C/^{12}C$ Isotope Ratios of Acetic of Biological and Technical Origin. Biomedical Mass Spectrometry *8*, 1981, 496—490 — W. G. MEINSCHEIN, G. G. L. RINALDI, J. M. HAYES, D. A. SCHOELLER, Intramolecular Isotopic Order in Biologically Produced Acetic Acid, *1*, 1974, 172—174). Les résultats sont donc connus et le composé sert de substance-test pour le procédé selon l'invention.

*Préparation de échantillons:* l'échantillon purement biologique (I) a été obtenu à partir d'un vinaigre de vin 8,5° résultant d'une fermentation de surface "à l'ancienne" pendant 21 jours (vinaigre "Vieille Réserve" MARTIN POURET, ORLEANS). Dans une installation à extraction continue, on extrait 1 litre de ce vinaigre par 1,5 litre d'éther isopropylique pendant au moins 24 heures. L'acide acétique ainsi extrait est isolé et purifié par distillations fractionnées. On obtient environ 60 g d'acide acétique, qui reproduit essentiellement la composition en carbone-13 de l'éthanol du vin de départ.

Comme écchantillon d'origine technique (II), on a utilisé l'acide acétique glacial de RIEDEL-DE-HAEN (SEELZE, R.F.A.). Ce composé fabriqué à partir de l'éthylène, produit secondaire du procédé de craquage du pétrole, par oxydation de l'acétaldéhyde (procédé WACKER-HÖCHST). L'acide acétique, obtenu à partir de cet acétaldéhyde, est ensuite utilisé pour la fabrication d'acétate de polyvinyle. Par hydrolyse partielle de ce produit, on procède à une récupération d'une partie de cet acide acétique. Cet acide acétique dit de récupération est particulièrement pur du point de vue chimique et vendu tel quel. Plusieurs étapes de ce mode de fabrication sont susceptibles d'entraîner un fractionnement des isotopes du carbone tel que le taux en carbone-13 du groupement carboxyle se trouve diminué unilatéralement. Selon l'invention, on a trouvé que cette répartition isotopique est inverse de celle pour l'acide acétique dorigine bio-synthétique.

On a également utilisé un mélange équimoléculaire (III) des échantillons (I) et (II).

On a utilisé comme quatrième échantillon (IV) l'acide acétique glacial de MERCK (DARMSTADT, R.F.A.), pour lequel on a trouvé une distribution intramoléculaire strictement "biologique". On a constaté ultérieurement que ce produit provient de la distillation du bois.

Aux quatre échantillons d'acide acétique, on a ajouté environ 20% en volume d'eau lourde. Par adjonction de traces de trichlorure de gadolinium ($GdCl_3$), on a établi un temps moyen de relaxation magnétique $T_2$ du carbone-13 voisin d'une seconde. L'échantillon était alors de 0,002 à 0,005 molaire par rapport au gadolinium. On a ajouté du sel disodique de l'acide éthylènediaminotétracétique = EDTA (TITRIPLEX III, MERCK) comme complexant, en quantité molaire double par rapport au gadolinium.

*Mesure de la répartition isotopique par résonance magnétique nucléaire du carbone-13.*

On prend soin d'assurer un rapport signal/bruit suffisant et une parfaite proportionnalité entre le nombre des noyaux résonnants et l'amplitude des signaux en réalisant les conditions expérimentales suivantes.

On a procédé à une simple intégration des deux signaux de carbone-13 qui sont éloignés de 160 ppm.

10 000 passages, 0,2: Hz/point, $T_3$ = 10 s.

Selon le type de sonde R.M.N., on a utilisé 0,7 ml (tubes de 5 mm) ou 2 ml (tubes de 10 mm) de l'échantillon.

*Distinction de l'origine de l'acide acétique.*

Pour chaque échantillon, on a calculé la surface des deux signaux du carbone-13, on a fait la moyenne de ces surfaces et déterminé l'écart Δ.

$$\Delta = \frac{S_{max} - S_{min}}{S_m}$$

$S_{max}$ = surface du signal qui correspond à la position la plus riche en $^{13}C$
$S_{min}$ = surface du signal qui correspond à la position la moins riche en $^{13}C$
$S_m$ = moyenne des surfaces de tous les signaux pour la molécule.

| Echantillon | Taux relief positionnel en carbone-13 $CH_3$ — COOH |
|---|---|
| I | 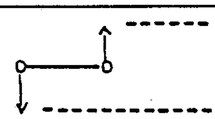 Δ = + 12‰ |
| II | 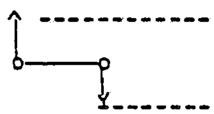 Δ = - 10‰ |
| III | 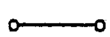 Δ ≠ 0 |
| IV | 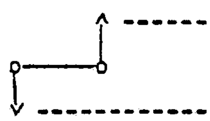 Δ = + 12‰ |

Le procédé selon l'invention permet donc de faire d'une manière directe, rapide et non destructive une distinction nette entre l'acide 100% à base de vin (I) qui présente une position hydrophile (—COOH) 12% plus riche en carbone-13 que la position hydrophile ($CH_3$) et l'échantillon technique utilisé (II) où la situation est presque inversée. Ces résultats sont en accord avec ceux obtenus à l'aide de la technique antérieure. Dans un mélange comme l'échantillon (III), les concentrations relatives peuvent être déterminées avec une précision d'environ 20% avec les appareils actuellement sur le marché.

Exemple 2

*Détermination de l'origine d'acides aminés, particulièrement de l'acide aspartique.*

Les conditions expérimentales sont identiques à celles décrites dans l'exemple n° 1.

*Préparation des échantillons.*

On a utilisé les acides aminés sérine (Ser), thréonine (Thr), acide glutamique (Glu) et acide aspartique (Asp). Leurs isomères optiques L proviennent des firmes MERCK (DARMSTADT, R.F.A.) et FLUKA (BUCHS,

Suisse). Ils sont fabriqués en culture sous-marine par des mutants de micro-organismes qui produisent sélectivement un seul acide aminé. Pour Asp, on a examiné également le racémate D/L, produit d'origine technique, qui est fabriqué à partir du gaz de craquage du pétrole ou de gaz de cokerie, par l'intermédiaire de l'anhydride maléique.

On a préparé des solutions de ces acides aminés dans l'leau lourde. Afin d'augmenter la solubilité, on a établi un milieu acide (acide chlorhydrique). Pour réduire les temps de relaxation du carbone-13, on a ajouté des traces de chlorure de gadolinium comme décrit précédemment.

*Résultats*

Les caractéristiques isotopiques suivantes ont été déterminées pour les trois échantillons suivants:

| Echantillon | Origine | Concentration mol/l | pH | Détermination semi-quantitative: taux relatif positionnel en carbone-13 |
|---|---|---|---|---|
| L-Ser | biol. | 4,5 | 2,2 | 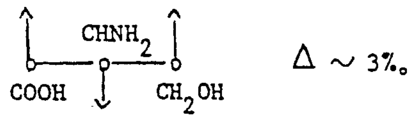 |
| L-Thr | biol. | 2,5 | 0,5 | 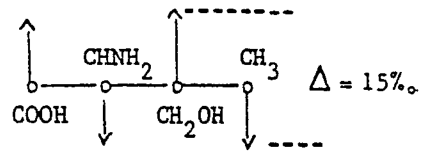 |
| L-Glu | biol. | 2,0 | 0,1 | 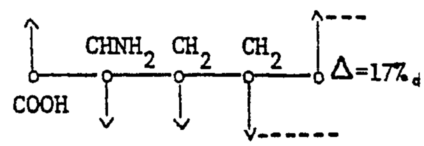 |

On donne ci-après les résultats chiffrés obtenus pour l'acide aspartique L-Asp (origine biologique) et D/L-Asp (racémate-origine technique).

Les deux spectres ont été enregistrés dans des conditions strictement identiques, de sorte que la courbe de réponse du spectromètre est la même.

| groupes | L-Asp (biologique) | | D/L-Asp (technique) | |
|---|---|---|---|---|
| | unités de* surface | différence en ‰ par rapport à la moyenne | unités de* surface | Différence en ‰ par rapport à la moyenne |
| $C_\gamma O$ | 1998±10 | + 2 | 1906 | −28 |
| C'O | 2023 | +15 | 1996 | +18 |
| $C_\alpha$ | 1973 | −10 | 1990 | +15 |
| $C_\beta$ | 1979 | − 7 | 1950 | − 5 |

*mesurées avec un planimètre (OTT, type 131 L, KEMPTEN, RFA) permettant une précision de 0,1% en utilisant un bras de traçage de 50 cm.

On peut à partir de ces résultats représenter schématiquement les deux acides aspartiques de la manière suivante:

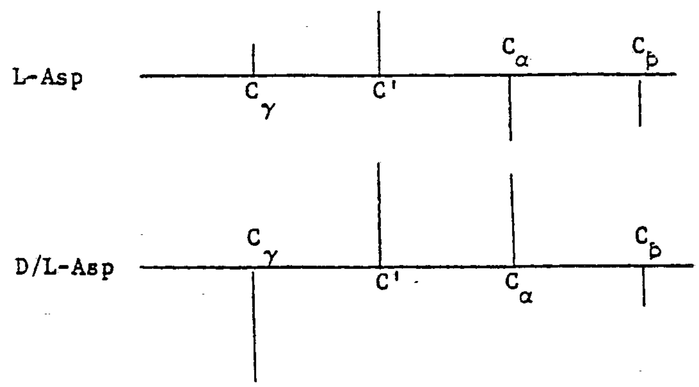


Comme cela à déjà été observé pour l'acide acétique d'origine biologique, on trouve pour tous les acides aminés biologiques des tableaux ci-dessus que les positions à caractère hydrophile et/ou facilement recyclables pendant le métabolisme sont enrichies en carbone-13 par rapport à la teneur isotopique moyenne de la molécule, les positions à caractère hydrophobe par contre sont appauvries en ce même isotope. Le groupement $C_\alpha$ des acides aminés se comporte comme une position à caractère hydrophobe.

Il n'était pas prévisible que la complexité quasi illimitée des interactions biologiques aboutisse à un schéma de répartition isotopique finale aussi simple et généralement valable, schéma qui, dans son application analytique, permet une première orientation rapide, sand obligation d'avoir recours à un composé de référence.

L'acide aspartique technique (D/L) présente une répartition isotopique presque inverse de celle observée pour le composé biologique (L-Asp). Bien que les deux produits soient considérés comme étant chimiquement identiques, le procédé selon l'invention permet de déterminer sans ambiguité leur origine respective.

Le taux isotopique global en carbone-13 (paramètre a défini ci-dessus) a été déterminé pour l'acide glutamique L. La molécule contient 10,75‰ $^{13}C$ par rapport à la totalité du carbone ($^{12}C$ + $^{13}C$) ce qui représente un appauvrissement de 0,27‰ en valeur absolue lorsqu'on prend comme référence l'abondance naturelle de cet isotope (11,12% $^{13}C$). L'appauvrissement relatif en $^{13}C$ de ce composé est donc de 25%. Pour obtenir le taux global en carbone-13, on utilise de préférence pour les petites molécules (<20 atomes de carbone) la combustion totale et l'analyse du rapport $^{13}CO_2/^{12}CO_2$ (technique ancienne), alors que, pour des molécules plus grandes, la spectrométrie de masse à désorption par champ est plus avantageuse.

*Exemple de réalisation n° 3: détermination de l'origine de l'alcool éthylique*

L'alcool éthylique présente, en fonction de son origine, des modifications assez spectaculaires de son taux en deutérium. Lorsqu'on compare les alcools de différentes origines bio-synthétiques, on touche également le problème import'ant de la chaptalis'ation des vins. L'origine d'un alcool n'a pu être déterminée jusqu'à présent qu'en utilisant simultanément les taux isotopiques globaux (paramètre a) et positionnels (paramètres c) et en deutérium et en carbone-13. Les effets sont moins spectulaires pour le carbone-13, mais moins sensibles aux facteurs variables de l'environnement.

Le procédé selon l'invention basé sur la détermination des rapports des isotopomères essentiels de l'alcool (paramètres d) permet une détermination précise de l'origine. Parmi les $2^N(N'+1)(N''+1) = 2^2(3+1)(2+1) = 48$ isotopomères possibles de l'éthanol

$N^2$ = 2 positions non équivalentes du carbone,

N' = 3 positions équivalentes d'hydrogène méthylique,

N'' = 2 positions équivalentes d'hydrogène méthylénique, le proton hydroxylique échangeable n'étant pas compté, les six isotopomères suivants participent avec une probabilité plus élevée que 0,01%: $^{12}CH_3$ $^{12}CH_2OH$, $^{13}CH_3$ $^{12}CH_2OH$, $^{12}CH_3$ $^{13}CH_3OH$, $^{13}CH_3$ $^{13}CH_2OH$, $^{12}CH_2D^{12}CH_2OH$ et $^{12}CH_3$ $^{12}CHDOH$. Dans le tableau ci-dessous, le rapport de ces isotopomères ressort semi-quantitativement.

*Préparation des échantillons*

Les alcools ont été préparés et/ou extraits selon un procédé classique (L. GATTERMANN, H. WIELAND, Praxis des Organischen Chemikers, Walter de Gruyter-Verlag, BERLIN, 1954, p. 350—1).

On a utilisé de l'alcool en provenance d'un vin de table rouge 10° de Béziers et d'un vin rouge d'Algérie 12° qui ont à peu près les mêmes caractéristiques isotopiques (échantillon I), d'un vin blanc Sylvaner 10° qui montre une chaptalisation (II), de l'alcool de provenance de sucre de betterave (III), de sucre de canne et glucose de maïs (IV). On a également examiné un alcool techno-synthétique (V) à base d'éthylène, gaz de craquage de produits de pétrole.

*Resultats*

Les résultats semi-quantitatifs sont présentés dans le tableau suivant, en utilisant pour la répartition positionnelle des isotopes le symbole défini et déjà utilisé ci-dessus. Les taux isotopiques globaux (appauvrissement en isotope lourd) obtenus en utilisant comme étalon intermédiaire un échantillon défini d'amidon de blé sont exprimés en ‰ par rapport au standard isotopique international tel que défini par H. CRAIG Geochim. Cosmochim. Acta 12,133—149 (1957).

| Echantillon | taux isotopique (‰) deutérium global | positionnel | carbone-13 global | positionnel |
|---|---|---|---|---|
| I (vigne) | −50 | 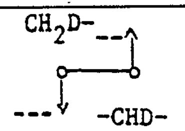 | −25 | 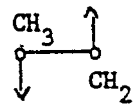 |
| II (vigne + sucre) | −40 | 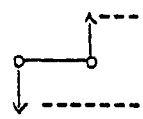 | −22 | 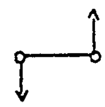 |
| III (sucre betterave) | −20 | 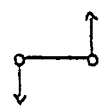 | −20 | 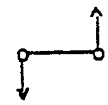 |
| IV (sucre canne, glucose de maïs) | −20 | 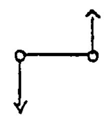 | − 5 | 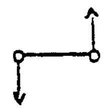 |
| V (produits pétroliers) | −60 | 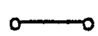 | −30 | 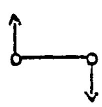 |

Δ = 10—30‰ Δ = 10—15‰

Une distinction nette entre les alcools biologiques (I—IV) et l'alcool technique (V) se manifeste par tous les paramètres.

A l'intérieure des échantillons biologiques, la différence est très nette entre l'alcool en provenance de la vigne (I, II) et de la betterave (III) d'une part (plantes $C_3$, dont le produit primaire de la photosynthèse est une molécule à trois atomes de carbone) et l'alcool à base de canne à sucre ou de maïs (IV) d'autre part (plantes $C_4$, dont le produit primaire est une molécule à quatre carbones). Le critère ici est le taux global en carbone-13.

Il existe également une différence entre l'alcool en provenance de la vigne (I) et celui en provenance de la betterave (III) aussi bien pour le deutérium que pour le carbone-13. Mais le taux en deutérium est extrêmement sensible aux facteurs extérieurs et saisonniers. Il décroît particulièrement

— avec la latitude géographique
— avec l'altitude
— lorsque la température baisse
— lorsqu'on s'éloigne de l'influence maritime
— en passant de la Méditérranée à l'Océan Atlantique
— lorsque le fruit est recueilli prématurément.

Le procédé selon l'invention convient également pour déterminer l'origine des acides gras. En plus en l'effet indiqué ci-dessus pour les autres subtances (comportement des groupes à caractère hydrophobe et hydrophile), on a trouvé que pour un acide gras naturel en provenance de plantes C3, l'extrêmité hydrophobe est plus pauvre en $^{13}C$ que l'extrêmité hydrophile bien qu'il s'agisse chimiquement des mêmes carbones ($—CH_2—$). On a constaté d'autre par une faible alternance régulière des abondances, de telle sorte qu'une semi-synthèse à partir de deux fractions naturelles peut être détectée par le procédé selon l'invention.

Le procédé selon l'invention a d'autres applications dans des domaines très variés. On notera par exemple que le procédé de l'invention peut être utilisé pour déterminer les conditions de croissance

optimales d'une plante donnée puisque l'on a constaté que la discrimination isotopique est minimale lorsque les conditions écologiques d'une plante sont optimales. Un autre exemple d'application du procédé est la détermination des substances organiques de l'animal pour déceler la manière dont il a été nourri. Certains métabolismes anormaux chez l'homme et l'animal sont suceptibles d'être détectés par l'analyse isotopique positionnelle. Le procédé de l'invention permet de nombreuses extensions et est susceptible de devenir ainsi une "véritable radiographie de la matière organique".

**Revendications**

1. Procédé pour identifier et, le cas échéant, pour déterminer quantitativement les origines bio- et/ou techno-synthétiques de substances organiques en fonction de leur taux global et de leur matrice caractéristique de répartition intramoléculaire en isotopes légers, stables et magnétiquement actifs, caractérisé en ce qu'il consiste à déterminer, en abondance naturelle, la répartition isotopique positionnelle d'au moins un isotope léger, stable et magnétiquement actif autre que le deuterium par résonance magnétique nucléaire (R.M.N.) quantitative par transformée de Fourier.

2. Procédé selon la revendication 1, caractérisé en ce qu'il consiste à enregistrer de façon quantitative et dans des conditions assurant une sensibilité suffisante et une parfaite proportionnalité entre le nombre des noyaux résonnants et l'amplitude du signal, les spectres de ces noyaux, à calculer la surface des différentes raies de ce signal et à comparer lesdites surfaces par rapport à la moyenne desdites surfaces.

3. Procédé selon l'une des revendications 1 ou 2, caractérisé en ce que l'isotope léger est le carbone-13.

4. Procédé selon l'une quelconque des revendications 1 à 3, caractérisé en ce que, lors de l'enregistrement du spectre R.M.N., le nombre de passages accumulés est compris entre 100 et 50 000, la résolution numérique est comprise entre 0,8 et 0,05 Hz/point et en ce que l'angle de mutation est de 90°C.

5. Procédé selon l'une quelconque des revendications 1 à 4, caractérisé en ce que l'isotope est le carbone-13 et en ce que le nombre de passages est compris entre 5 000 et 20 000, de préférence 5 000, et la résolution numérique est de 0,1 à 0,2 Hz/point.

6. Procédé selon l'une quelconque des revendications 1 à 5, caractérisé en ce que l'on calibre la sensibilité du spectromètre R.M.N., en fonction de la fréquence sur le domaine de fréquence utilisé et aux conditions d'enregistrement choisie, avec un mélange de calibrage contenant des composés de composition isotopique globale connue tous miscibles entre eux, inertes les uns vis-à-vis des autres, lesdits composés produisant chacun une seule raie pour un isotope donné, le mélange étant tel que les raies desdits composés soient espacées de façon relativement régulière sur toute la largeur du spectre.

7. Procédé selon l'une quelconque des revendications 1 à 6, caractérisé en ce qu'il consiste à déterminer la répartition isotopique positionnelle du carbone-13 et en ce qu'il comprend en outre une détermination de la répartition isotopique positionnelle du deutérium.

8. Procédé selon la revendication 6, caractérisé en ce que le mélange de calibrage est un mélange dans l'eau lourde des composés suviants:

- — thiocyanate de sodium NaSCN
- — urée $NH_2CO\ NH_2$
- — diméthylsulfoxyde $(CH_3)_2SO$
- — glycol $(CH_2OH)_2$
- — alcool méthylique $CH_3OH$

en des quantités tels que chaque composé apporte la même quantité molaire de carbone.

9. Procédé selon l'une quelconque des revendications 1 à 8, caractérisé en ce qu'il comporte en outre une étape de détermination isotopique dudit isotope léger par spectrométrie de masse à désorption par champ.

10. Procédé selon la revendication 1, caractérisé en ce qu'on procède à une mesure différentielle par rapport à une position donnée de l'isotope léger dans la molecule, ladite position étant prise comme référence isotopique interne.

11. Procédé selon la revendication 1, caractérisé en ce qu'on enregistre, dans des conditions identiques, les spectres en module.

12. Procédé selon la revendication 6, caractérisé en ce que le calibrage interne du spectre est automatisé à l'aide d'une fonction polynomiale de compensation.

13. Procédé selon l'une des revendicatons 1 ou 3, caractérisé en ce qu'on utilise un moyen standard d'analyse sous la forme d'une matrice de répartition isotopique prédéterminée par la formule chimique structurale de la substance organique étudiée, celle-ci présentant un schéma isotopique interne selon lequel les groupes à caractère hydrophile et/ou facilement recyclables pendant le métabolisme sont enrichis en isotope lourd par rapport à la teneur isotopique moyenne de la molécule, les groupes à caractère hydrophobe par contre sont appauvris en isotope lourd.

14. Procédé selon l'une quelconque des revendications 1 à 7, caractérisé en ce que le spectromètre est couplé avec un microprocesseur dans lequel on mémorise des compositions isotopiques standard.

15. Mélange de calibrage d'un spectrométre R.M.N. pour la détermination de la répartition isotopique du carbone-13 en oue d'identifier et, le cas échéant, de déterminer quantitativement les origine, bio- et/ou techno-synthétiques de substances organiques, suivant le procédé selon la revendication 1, caractérisé en ce qu'il est un mélange dans l'eau lourde de:

— thiocyanate de sodium NaSCN
— urée $NH_2CO\ NH_2$
— diméthylsulfoxyde $(CH_3)_2SO$
— glycol $(CH_2OH)_2$
— alcool méthylique $CH_3OH$

en des quantités telles que chaque composé apporte la même quantité molaire de carbone.

16. Tube de calibrage, contenant, le mélange selon la revendication 15.

17. Tube de calibrage selon la revendication 16, caractérisé en ce qu'il est scellé.

## Patentansprüche

1. Verfahren zur qualitativen und ggf zur quantitativen Bestimmung der biologischen und/oder synthetischen Herkunft organischer Substanzen mit Hilfe ihres Gesamtgehaltes und der charackteristischen intromolekularen Verteilung an stabilen, magnetisch aktiven Isotopen der leichten Elemente, dadurch gekennzeichnet, dass die positionelle Isotopenverteilung mindestens eines solchen leichten, stabilen und magnetisch aktiven Isotopes unter Ausschluss des Deuteriums mit Hilfe quantitativer Fourier-Transform-Kernresonanz (NMR) in natürlicher Häufigkeit gemessen wird.

2. Verfahren nach Anspruch 1, dadurch gekennzeichnet, dass Spektren dieser Kerne quantitativ und unter Bedingungen aufgenommen werden, die eine hinreichende Empfindlichkeit und eine genaue Proportionalität zwischen der Anzahl der resonierenden Kerne und der Signal-amplitude gewährleisten, dass die Flächen unter den Signalen eines solchen Spektrumsbestimmt und zu dem Mittelwert der genannten Spektralflächen ins Verhältnis gesetzt werden.

3. Verfahren nach einem der Ansprüche 1 oder 2, dadurch gekennzeichnet, dass das leichte Isotop Kohlenstoff 13 ist.

4. Verfahren nach einem der Ansprüche 1 bis 3, dadurch gekennzeichnet, dass für die Aufnahme der NMR-Spektren die Anzahl der akkumulierten Durchgänge zwischen 100 und 50.000, die Auflösung zwischen 0,8 und 0,05 Hz pro Datenpunkt und der Nutationswinkel 90° beträgt.

5. Verfahren nach einem der Ansprüche 1 bis 4, dadurch gekennzeichnet, dass das betrachtete Isotop Kohlenstoff 13 ist, dass die Anzahl der akkumulierten Durchgänge zwischen 5.000 und 20.000, vorzugsweise 5.000 beträgt und die Auflösung 0,1 bis 0,2 Hz/Datenpunkt leigt.

6. Verfahren nach einem der Ansprüche 1 bis 5, dadurch gekennzeichnet, dass die Spektrometerempfindlichkeit als Funktion der Signalfrequenz und der gewählten Aufnahmeparameter über den gewählten Frequenzbereich hin mit Hilfe einer Eichlösung bestimmt wird, wobei eine solche Eichlösung aus einer Mischung von Substanzen bekannten Gesamtisotopengehaltes besteht, wobei keine der genannten Substanzen mit einer anderen chemisch reagiert und jede für das gegebene Isotop nur eine einzige Kernresonanzlinie erzeugt und die Mischung aus Lösungskomponenten besteht, deren jeweilige Linien in ungefähr regelmässigem Abstand über den gesamten Frequenzbereich des Spektrums verteilt sind.

7. Verfahren nach einem der Ansprüche 1 bis 6, dadurch gekennzeichnet, dass es in der Bestimmung der positionellen Isotopenverteilung von Kohlenstoff 13 besteht und gleichzeitig eine solche Bestimmung von Deuterium enthalten kann.

8. Verfahren nach Anspruch 6, dadurch gekennzeichnet, dass die Eichlösung ein in schwerem Wasser gelöstes Gemisch aus folgenden Verbindungen ist;

— Natriumthiocyanat NaSCN
— Harnstoff $NH_2CONH_2$
— Dimethylsulfoxid $(CH_3)_2SO$
— Glykol $(CH_2OH)_2$
— Methylalkohol $CH_3OH$

die in der Weise gemischt sind, dass jede Verbindung ungefähr die gleiche molare Konzentration in Kohlenstoff einbringt.

9. Verfahren nach einem der Ansprüche 1 bis 8, dadurch gekennzeichnet, dass unter anderem auch eine Bestimmung des Gehaltes an dem gegebene leichten Isotop mit Hilfe der Feld-Desorptions-Massenspektroskopie durchgeführt wird.

10. Verfahren nach Anspruch 1, dadurch gekennzeichnet, dass das Differenzpektrum im Hinblick auf eine gegebene, aus demselben Molekül resultierende Linie eines leichten Isotopes aufgenommen wird, wobei die letztere als intramolekularer Isotopenstandard dient.

11. Verfahren nach Anspruch 1, dadurch gekennzeichnet, dass unter Bedingungen das Modul-Spektrum aufgenommen wird.

12. Verfahren nach Anspruch 6, dadurch gekennzeichnet, dass die interne Eichung des Spektrums mit Hilfe einer Polynom-Funktion erfolgt, die die Empfindlichkeiten inden verschiedenen Frequenzbereichen automatisch normalisiert.

13. Verfahren nach einem der Ansprüche 1 oder 3, dadurch gekennzeichnet, dass man als mittleren Standard ein durch die chemische Strukturformal der untersuchten organischen Substanz vorgegebenes intramolekulares Isotopenverteilungsschema vorgibt, das darin besteht, dass hydrophile, und/oder während des Stoffwelchsels leicht rezyklierbare Gruppen an dem schwereren Isotop angereichert, Gruppen mit hydrophobem Charakter dagegen daran abgereichert sind.

14. Verfahren nach einem der Ansprüche 1 bis 7, dadurch gekennzeichnet, dass das Spektrometer mit einem Mikroprozessor verbunden ist, der die isotopische Standard-Verteilungen speichert.

15. Eichmischung für ein NMR-Spektrometer zur Bestimmung der Isotopenverteilung an Kohlenstoff 13, die der qualitativen und ggf quantitativen Bestimmung der biologischen und/oder synthetischen Herkunft organischer Substanzen nach Anspruch 1 dient, dadurch gekennzeichnet, dass sie ein in schwerem Wasser gelöstes Gemisch aus folgenden Substanzen darstellt:

— Natriumthiocyanat NaSCN
— Harnstoff $NH_2CONH_2$
— Dimethylsulfoxid $(CH_3)_2SO$
— Glykol $(CH_2OH)_2$
— Methylalkohol $CH_3OH$

die in der Weise gemischt sind, dass jede Verbindung ungefähr die gleiche molare Konzentration in Kohlenstoff einbringt.

16. NMR-Eichröhre, die eine Mischung nach Anspruch 15 enthält.

17. Eichröhre nach Anspruch 16, die durch Zuschemelzen verschlossen ist.

**Claims**

1. Process to idenfity and, in certain cases, quantitatively determine the biological and/or technical origins of organic substances using the overall concentration and the intramolecular distribution of light, stable and magnetically active isotopes, especially carbon-13. The said process consists in determining, at the natural abundance level, the positional isotopic distribution of at least one light, stable and magnetically active isotope other then deuterium by means of Fourier transform quantitative nuclear magnetic resonance (NMR).

2. The process, according to claim 1, consists in recording (by quantitative nuclear magnetic resonance) the spectra of the nuclei concerned in particular carbon-13, under conditions ensuring sufficient sensitivity, accurate proportionality between the number of reasonant nuclei and the area of the corresponding signal and in computing the area of the various lines, in order to compare each value to the average value over all lines.

3. The process, according to claims 1 and 2, is applied to carbon-13 as the light, stable magnetically active isotope.

4. The process according to any one of claims 1 to 3, consists in recording the NMR spectrum using the following parameters; total number of scans: between 100 and 50.000; numerical resolution: between 0.8 and 0.05 Hz/point; angle of nutation: 90°.

5. The process, according to any one of claims 1 to 3 is characterized by the facts that the isotope is carbon-13, the number of scans lies between 5.000 and 20.000, preferably 5.000, and the digital resolution is 0.1 to 0.2 Hz/point.

6. The process according to any of the claims 1 to 5, is characterized in that the spectrometer sensitivity is determined as a function of frequency (over the frequency range of interest), using a calibration mixture, and recording conditions identical to those used for the unknown. The calibration mixture contains compounds of known overall isotopic composition; all of which are inert and fully miscible with one another. These reference compounds each produce a single NMR line for a given isotope and are chosen such that their lines are approximately evenly spaced over the spectral range.

7. The process according to any one of claims 1 to 6 characterized in that it consists in determining the positional isotopic distribution of carbon-13 and involves also the determination of the positional isotopic distribution of deuterium, in order to identify, and in certain cases, quantitatively determine the biological and/or technical origins of organic substances, according to claim 1.

8. For the process, according to claim 6, the calibration sample is a mixture, in heavy water, of the following compounds:

— sodium thiocyanate NaSCN
— urea $(NH_2)_2$ CO
— dimethylsulphoxide $(CH_3)_2$ SO
— ethylene glycol $(CH_2CH)_2$
— methyl alcohol $CH_3OH$

in amounts such that each compound contributed the same molar amount of carbon.

9. Process, according to any one of the claims 1 to 8, characterized in that it involves also the assay of the light isotope by field desorption mass spectrometry.

10. Process according to claim 1, characterized in that a difference measurement is carried out, with respect to a given site in the molecule, taken as an internal isotopic reference.

11. Process according to claim 1, characterized by the recording under identical conditions, of magnitude spectra.

12. Process according to claim 6, characterized in that the internal calibration of the spectrum is automated by means of a polynomial compensation function.

13. Process, according to claims 1 or 3, characterized by the use, as an analytical reference, of a matrix of isotopic distribution. The matrix is predetermined by the structural formula of the organic compound under investigation. It presents an internal isotopic diagram according to which groups with hydrophilic character and/or groups which are easily recycled during metabolism are enriched in the heavy isotope with respect to the average isotopic content of the molecule. On the other hand, groups with hydrophobic character are depleted in heavy isotope.

14. Process according to any one of the claims 1 to 7, characterized in that standard isotopic compositions are stored in the memory of a microcomputer coupled to the spectrometer.

15. Calibration mixture for the determination of the isotopic distribution of carbon-13, characterized in that it is a mixture in heavy water of:

— sodium thiocyanate NaSCN
— urea $NH_2$ CO $NH_2$
— dimethylsulphoxide $(CH_3)_2$ SO
— glycol $(CH_2OH)_2$
— methyl alcohol $CH_3OH$

in amounts such that each compound contributed the same molar amount of carbon.

16. Calibration tube, containing the mixture according to claim 14.

17. Calibration tube according to claim 15, characterized in that it is sealed.